# EUROPÄISCHE PATENTSCHRIFT

(11) **EP 2 771 591 B1**
(45) Veröffentlichungstag und Bekanntmachung des Hinweises auf die Patenterteilung: **13.12.2017**
(21) Anmeldenummer: 12778649.9
(22) Anmeldetag: 02.10.2012
(51) Int. Cl.: F16F 7/108, H05K 1/02, F16F 7/10

(54) **SCHWINGUNGSTILGUNGSVORRICHTUNG FÜR EINEN SCHALTUNGSTRÄGER UND ELEKTRONISCHES GERÄT MIT EINEM SCHALTUNGSTRÄGER**
VIBRATION DAMPING DEVICE FOR A CIRCUIT CARRIER, AND ELECTRONIC DEVICE HAVING A CIRCUIT CARRIER
DISPOSITIF D'AMORTISSEMENT DES VIBRATIONS POUR UN SUPPORT DE CIRCUIT ET APPAREIL ÉLECTRONIQUE ÉQUIPÉ D'UN SUPPORT DE CIRCUIT

(30) Priorität: 27.10.2011 DE 102011085294
(43) Veröffentlichungstag der Anmeldung: 03.09.2014
(73) Patentinhaber: Robert Bosch GmbH, 70442 Stuttgart (DE)
(72) Erfinder: MOELLER, Markus, 72793 Pfullingen (DE); FRESSER, Heiko, 70599 Stuttgart (DE); RAUCH, Markus, 70567 Stuttgart (DE)
(86) Internationale Anmeldenummer: PCT/EP2012/069430
(87) Internationale Veröffentlichungsnummer: WO 2013/060555

(56) Entgegenhaltungen:
- EP-A2- 1 744 302
- DE-A1-102004 058 675
- DE-A1-102007 012 925
- US-A1- 2007 068 756
- US-A1- 2011 205 165

## Beschreibung

### Stand der Technik

Die Erfindung geht aus von einer Schwingungstilgungsvorrichtung für einen Schaltungsträger nach der Gattung des unabhängigen Patentanspruchs 1 sowie von einem elektronischen Gerät mit einem Schaltungsträger nach Gattung des unabhängigen Patentanspruchs 7.

Aus dem Stand der Technik, insbesondere aus dem Maschinenbau, sind elektrische Geräte, wie beispielsweise Elektromotoren und Waschmaschinen, mit einer Schwingungstilgungsvorrichtung bekannt. Des Weiteren sind aus dem Bauwesen, beispielsweise bei Brücken und Hochhäuser, Schwingungstilgungsvorrichtungen mit einer Tilgermasse bekannt. Das Prinzip der Schwingungstilgung mittels einer Tilgermasse beruht hierbei darauf, dass durch eine zweite schwingende Masse dem schwingenden System Energie entzogen wird, wodurch sich die Schwingungsüberhöhung reduziert. Üblicherweise sind die bekannten Schwingungstilger richtungsabhängig, d.h. nicht über 360° in einer Fläche einsetzbar.

In der Offenlegungsschrift DE 196 39 556 A1 wird eine Schwingungstilgungsvorrichtung zur Tilgung von Schwingungen an Bauelementen und/oder Maschinenteilen beschrieben. Die beschriebene Vorrichtung weist ein Basisteil, eine Tilgermasse und eine in ihren Federeigenschaften veränderbare Gummifeder auf. Die Gummifeder ist zwischen dem Basisteil und der Tilgermasse angeordnet, wobei über die Veränderung der Federeigenschaften verschiedene und/oder vorbestimmte und/oder einstellbare Frequenzen, welche von außen auf das Basisteil übertragen werden, getilgt und/oder gedämpft werden können.

In der Offenlegungsschrift DE 198 21 165 A1 werden eine Schwingungstilgungsvorrichtung und ein Verfahren zur Dämpfung von Schwingungen beschrieben, welche an einem Übertragungselement und/oder an einer Außenwandung einer Lenksäule eines Kraftfahrzeugs auftreten. Hierbei weist die Schwingungstilgungsvorrichtung eine Tilgermasse und ein elastisches Koppelelement auf. Wobei das elastische Koppelelement mit der Tilgermasse in Wirkverbindung steht. Die Wirkverbindung kann über eine formschlüssige und/oder eine kraftschlüssige Verbindung hergestellt werden. Des Weiteren ist die Schwingungstilgungsvorrichtung in der Art ausgebildet, dass asymmetrische Schwingungen durch die Schwingungstilgungsvorrichtung gedämpft und/oder getilgt werden. Hierbei kann die Schwingungstilgungsvorrichtung innerhalb des Übertragungselements und/oder an einer Außenwandung angebracht sein um Schwingungen zu dämpfen und/oder zu tilgen.

In der Offenlegungsschrift DE 10 2004 058 675 A1 wird eine Schwingungstilgungsvorrichtung für einem Schaltungsträger mit mindestens einer Tilgermasse offenbart. Die mindestens eine Tilgermasse ist an dem Schaltungsträger befestigt und zwischen der mindestens einen Tilgermasse und dem Schaltungsträger ist ein elastischer Werkstoff mit einer definierten Steifigkeit und/oder Dämpfungseigenschaft angeordnet.

Zudem offenbaren die Dokumente DE 10 2007 012 925 A1, US 2007/0068756 A1 und EP 1 744 302 A2 Vorrichtungen, welche zur Dämpfung von Schwingungen einer Trägereinrichtung eingesetzt werden können.

### Offenbarung der Erfindung

Die erfindungsgemäße Schwingungstilgungsvorrichtung für einen Schaltungsträger und das erfindungsgemäße elektronische Gerät mit einem Schaltungsträger mit den Merkmalen der unabhängigen Patentansprüche 1 und 7 haben demgegenüber den Vorteil, dass mindestens eine Tilgermasse an dem Schaltungsträger befestigt ist und zwischen der mindestens einen Tilgermasse und dem Schaltungsträger ein elastischer Werkstoff mit einer definierten Steifigkeit und/oder Dämpfungseigenschaft angeordnet ist.

Ausführungsformen der vorliegenden Erfindung ermöglichen in vorteilhafter Weise eine Dämpfung und/oder eine Amplitudenreduktion und/oder eine Tilgung einer angreifenden äußeren Schwingung, durch eine Gegenschwingung mindestens einer Tilgermasse. Die mindestens eine Tilgermasse weist hierbei an einen Schaltungsträger in elektronischen Geräten angepasste Abmessungen auf. Die
Schwingungstilgungsvorrichtung ist zudem in vorteilhafter Weise einfach in der Serienproduktion von Schaltungsträgern applizierbar. Hierbei können in vorteilhafter Weise die einzelnen Komponenten, wie das elastische Dämpfungselement und die mindestens eine Tilgermasse, nacheinander an dem Schaltungsträger angebracht werden oder die mindestens eine Tilgermasse und das elastische Dämpfungselement bilden eine vormontierte Schwingungstilgungsvorrichtung, welche mit dem Schaltungsträger verbindbar ist. Auf diese Weise wird in vorteilhafter Weise eine günstige Produktion des Schaltungsträgers ermöglicht. Des Weiteren können kleinere Tilgermassen verwendet werden, welche Schwingungen bei typischen Schaltungsträgermassen reduzieren und/oder dämpfen und/oder tilgen. Des Weiteren ist in vorteilhafter Weise eine einfache und schnelle Anpassung der Tilgerparameter, wie beispielsweise der Tilgermasse, der Steifigkeit, und/oder der Dämpfungseigenschaften, zur Anpassung an viele Layouts, wie beispielsweise an eine variierenden Schaltungsträgermasse durch zusätzliche Bauteile, und damit an eine variierende Resonanzfrequenz, möglich.

Ausführungsformen der erfindungsgemäßen Schwingungstilgungsvorrichtung stellen mindestens eine Tilgermasse zur Verfügung. Hierbei ist die mindestens eine Tilgermasse an einem Schaltungsträger befestigt, wobei zwischen der mindestens einen Tilgermasse und dem Schaltungsträger ein elastischer Werkstoff mit einer definierten Steifigkeit und/oder Dämpfungseigenschaft angeordnet ist.

Erfindungsgemäß weist die Schwingungstilgungsvorrichtung eine Schale auf, in welcher der elastische Werkstoff und die mindestens eine Tilgermasse angeordnet sind. Der elastische Werkstoff kann dann als Füllstoff ausgeführt werden, welcher die mindestens eine Tilgermasse zumindest teilweise umgibt. Durch die Anordnung der Tilgermasse in einer Schale, muss der verwendete Füllstoff nicht standfest sein und kann in vorteilhafter Weise als Gel ausgeführt werden, wodurch sich die Anzahl der möglichen Füllstoffe erhöht. Zudem ist die mindestens eine Tilgermasse über einen Stab mit der Schale gekoppelt, wobei über die Materialeigenschaften des Stabes die Steifigkeitseigenschaften der Schwingungstilgungsvorrichtung eingestellt werden, und wobei über die Materialeigenschaften des Füllstoffs die Dämpfungseigenschaften der Schwingungstilgungsvorrichtung eingestellt werden. In vorteilhafter Weise kann die Schwingungstilgungsvorrichtung bei geeigneter Positionierung translatorische und rotatorische Schwingungsmoden mit nahezu gleicher Resonanzfrequenz gleichzeitig dämpfen
und/oder tilgen. Des Weiteren können in vorteilhafter Weise die Steifigkeitseigenschaften und die Dämpfungseigenschaften einfach über das gewählte Stabmaterial und über den gewählten Füllstoff eingestellt werden.

Durch die in den abhängigen Ansprüchen aufgeführten Maßnahmen und Weiterbildungen sind vorteilhafte Verbesserungen der im unabhängigen Patentanspruch 1 angegebenen Schwingungstilgungsvorrichtung für einen Schaltungsträger und des im unabhängigen Patentanspruch 9 angegebenen erfindungsgemäße elektronischen Geräts mit einem Schaltungsträger möglich.

In weiterer vorteilhafter Ausgestaltung der Schwingungstilgungsvorrichtung kann der elastische Werkstoff als Dämpfungsschicht ausgeführt werden, wobei über die Materialeigenschaften und/oder über die Geometrie der Dämpfungsschicht die Dämpfungseigenschaften und/oder die Steifigkeitseigenschaften der Schwingungstilgungsvorrichtung eingestellt werden können. Die Schwingungstilgungsvorrichtung kann in vorteilhafter Weise eine Schwingungsamplitude bei einer Resonanzfrequenz des Schaltungsträgers gezielt reduzieren und/oder dämpfen und/oder tilgen. Des Weiteren kann der elastische Werkstoff in vorteilhafter Weise direkt mit dem Schaltungsträger verbunden und vorzugsweise als Haftmittel für die mindestens eine Tilgermasse ausgeführt werden.

In weiterer vorteilhafter Ausgestaltung der erfindungsgemäßen Schwingungstilgungsvorrichtung kann der elastische Werkstoff die Bewegung der mindestens einen Tilgermasse in mindestens eine vorgegebene Raumrichtung freigeben. Dadurch kann in vorteilhafter Weise die gezielte Reduzierung und/oder Dämpfung und/oder Tilgung einer Schwingungsamplitude bei einer Resonanzfrequenz des Schaltungsträgers weiter verbessert werden, wobei die Dämpfung bzw. die Amplitudenreduktion durch die Gegenschwingung der Tilgermasse in unterschiedliche vorgegebene Richtungen erfolgen kann, und wobei die relevanten Abmessung der Tilgermasse an den korrespondierenden Schaltungsträger im elektronischen Steuergerät angepasst werden können.

In weiterer vorteilhafter Ausgestaltung der erfindungsgemäßen Schwingungstilgungsvorrichtung können die mindestens eine Tilgermasse und/oder der elastische Werkstoff auf die zu dämpfende Frequenz abgestimmt werden. Dadurch kann in vorteilhafter Weise die gezielte Reduzierung und/oder Dämpfung
und/oder Tilgung einer Schwingungsamplitude bei einer Resonanzfrequenz des Schaltungsträgers weiter verbessert werden. Auf diese Weise kann je nach Verbauort und den dort auftretenden Schwingungen die Schwingungstilgungsvorrichtung optimal an die äußeren Umstände angepasst werden.

In weiterer vorteilhafter Ausgestaltung der erfindungsgemäßen Schwingungstilgungsvorrichtung kann die Schwingungstilgungsvorrichtung über mindestens ein Befestigungsmittel an dem Schaltungsträger befestigt werden. Dies ermöglicht in vorteilhafter Weise die Verwendung einer Interfaceschicht, wie z.B. einer Metallscheibe, welche mit dem Schaltungsträger verbunden ist. Dadurch ist in vorteilhafter Weise eine SMD-Bestückung denkbar. Zudem sind weitere Befestigungsverfahren, wie beispielsweise kleben, schweißen, löten denkbar.

In weiterer vorteilhafter Ausgestaltung der erfindungsgemäßen Schwingungstilgungsvorrichtung ist das Befestigungsmittel an einer Kontaktfläche angebracht, welche an dem elastischen Werkstoff und/oder an der Schale angeordnet ist. In vorteilhafter Weise sind somit ein einfacher, kostengünstiger Aufbau und die Möglichkeit zur Serienfertigung bei der Schaltungsträgermontage möglich.

Ausführungsformen des erfindungsgemäßen elektronischen Geräts stellen mindestens einen Schaltungsträger zur Verfügung, welcher über Befestigungspins mit einem Gehäuse verbunden ist. Auf dem Schaltungsträger ist mindestens ein Bauteil befestigt. Äußere Schwingungen sind über das Gehäuse und/oder über die Befestigungspins auf den Schaltungsträger und/oder auf das mindestens eine Bauteil übertragbar. Das elektronische Gerät weist eine Schwingungstilgungsvorrichtung auf, welche die äußeren Schwingungen dämpft und/oder tilgt. Erfindungsgemäß weist die Schwingungstilgungsvorrichtung mindestens eine Tilgermasse auf, welche an dem Schaltungsträger befestigt ist, wobei zwischen der mindestens einen Tilgermasse und dem Schaltungsträger ein elastischer Werkstoff mit einer definierten Steifigkeit und/oder Dämpfungseigenschaft angeordnet ist.

Besonders vorteilhaft ist, dass die Schwingungstilgungsvorrichtung zur Schwingungstilgung an der Oberseite und/oder an der Unterseite des Schaltungsträgers befestigt ist. Dies ermöglicht in vorteilhafter Weise eine flexible Anordnung der Schwingungstilgungsvorrichtung, so dass kein Einbauraum verschwendet wird.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Darstellung eines ersten Ausführungsbeispiels eines erfindungsgemäßen elektronischen Geräts.
Fig. 2 zeigt eine schematische Darstellung eines zweiten Ausführungsbeispiels eines erfindungsgemäßen elektronischen Geräts.
Fig. 3 zeigt eine schematische Darstellung eines dritten Ausführungsbeispiels eines erfindungsgemäßen elektronischen Geräts.
Fig. 4 zeigt eine schematische Darstellung der auftretenden Dämpfungseigenschaften und Steifigkeitseigenschaften eines erfindungsgemäßen elektronischen Geräts gemäß Fig. 1 bis 3.

### Ausführungsformen der Erfindung

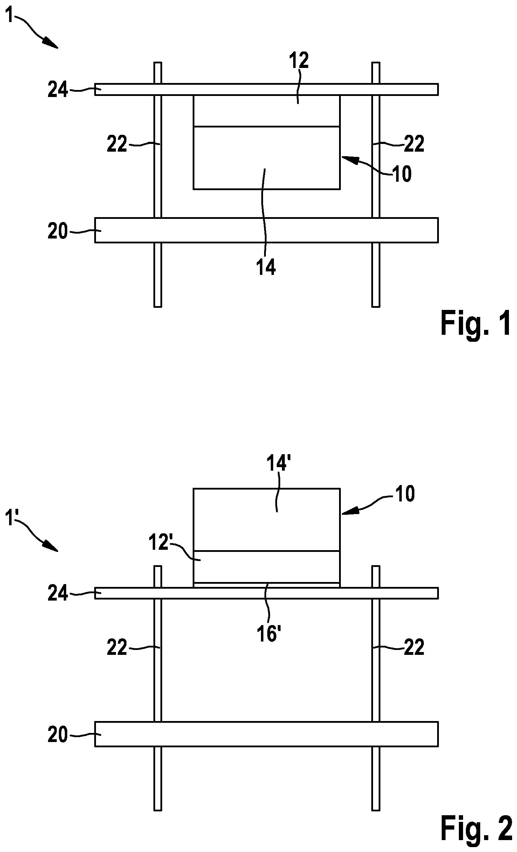

Wie aus Fig. 1 bis 4 ersichtlich ist, umfassen die dargestellten Ausführungsbeispiele eines elektronischen Gerätes 1, 1', 1" einen Schaltungsträger 24, welcher über Befestigungspins 22 mit einem Gehäuse 20 verbunden ist, wobei auf dem Schaltungsträger 24 mindestens ein nicht dargestelltes Bauteil befestigt ist, wobei äußere Schwingungen über das Gehäuse 20 und/oder über die Befestigungspins 22 auf den Schaltungsträger 24 und/oder auf das mindestens eine Bauteil übertragbar sind. Die Befestigungspins 22 dienen zur Fixierung des Schaltungsträgers 24 sowie zur elektrischen Anbindung des Schaltungsträgers 24. Das elektronische Gerät 1, 1', 1" weist eine Schwingungstilgungsvorrichtung 10, 10', 10" auf, welche die äußeren Schwingungen dämpft. Hierbei hat die Schwingungstilgungsvorrichtung 10, 10', 10" die Aufgabe, eine Amplitude bei einer Resonanzfrequenz des Schaltungsträgers 24 gezielt zu reduzieren bzw. zu dämpfen. Dabei ist die Schwingungstilgungsvorrichtung 10, 10', 10" einfach in der Serienproduktion von Leiterplattensteuergeräten applizierbar.

Erfindungsgemäß umfasst die Schwingungstilgungsvorrichtung 10, 10', 10" mindestens eine Tilgermasse 14, 14', 14", welche an dem Schaltungsträger 24 befestigt ist, wobei zwischen der mindestens einen Tilgermasse 14, 14', 14" und dem Schaltungsträger 24 ein elastischer Werkstoff 12, 12', 12" mit einer definierten Steifigkeit und/oder Dämpfungseigenschaft angeordnet ist. Die mindestens eine Tilgermasse 14, 14', 14" und/oder der elastische Werkstoff 12, 12', 12" wird über eine Steifigkeitseigenschaft k2, k2', k2" und/oder über eine Dämpfungseigenschaft D2, D2', D2"spezifisch auf eine zu dämpfende Resonanzfrequenz und/oder eine zu reduzierende Schwingungsamplitude des Schaltungsträgers 24 und/oder auf die zu dämpfende Frequenz abgestimmt.

In vorteilhafter Weise werden über die Materialeigenschaften und/oder über die Geometrie der Tilgermasse 14, 14', 14" und/oder des elastischen Werkstoffs 12, 12', 12" die Steifigkeitseigenschaften k2, k2', k2" der Schwingungstilgungsvorrichtung 10, 10', 10" einfach eingestellt. Des Weiteren werden über die Materialeigenschaften und/oder über die Geometrie des elastischen Werkstoffs 12, 12', 12" und der Tilgermasse auch die Dämpfungseigenschaften D2, D2', D2" der Schwingungstilgungsvorrichtung 10, 10', 10" eingestellt. Der elastische Werkstoff 12, 12', 12" gibt die Bewegung der mindestens einen Tilgermasse 14, 14', 14" in mindestens eine vorgegebene Raumrichtung frei.

Wie aus Fig. 1 weiter ersichtlich ist, weist das dargestellte erste Ausführungsbeispiel einer Schwingungstilgungsvorrichtung 10 einen elastischen Werkstoff 12 auf, welcher als Dämpfungsschicht ausgeführt ist, wobei über die Materialeigenschaften und/oder über die Geometrie der Dämpfungsschicht 12 die Dämpfungseigenschaften D2 und/oder die Steifigkeitseigenschaften k2 der Schwingungstilgungsvorrichtung 10 einstellbar sind. Im dargestellten ersten Ausführungsbeispiel ist die Tilgermasse 14 auf der Unterseite des Schaltungsträgers 24 befestigt. Dadurch kann die Höhe der Schwingungstilgungsvorrichtung 10 reduziert und eine optimale Ausnutzung des vorhandenen Bauraums erzielt werden. Des Weiteren ist der elastische Werkstoff im dargestellten ersten Ausführungsbeispiel als Haftmittel, beispielsweise als Kleber, ausgeführt und direkt mit dem Schaltungsträger und der Tilgermasse 14 verbunden. Dieser Aufbau erspart der Fertigung den Einsatz von zusätzlichen Befestigungsverfahren wie beispielsweise Schweißen, Löten, Schrauben usw.

Wie aus Fig. 2 weiter ersichtlich ist, weist das dargestellte zweite Ausführungsbeispiel einer Schwingungstilgungsvorrichtung 10' ebenfalls einen elastischen Werkstoff 12' auf, welcher als Dämpfungsschicht ausgeführt ist. Analog zum ersten Ausführungsbeispiel werden über die Materialeigenschaften und/oder über die Geometrie der Dämpfungsschicht 12' die Dämpfungseigenschaften D2' und/oder die Steifigkeitseigenschaften k2' der Schwingungstilgungsvorrichtung 10' eingestellt. Im Unterschied zum ersten Ausführungsbeispiel ist im dargestellten zweiten Ausführungsbeispiel die Tilgermasse 14' auf der Oberseite des Schaltungsträgers 24 befestigt. Des Weiteren ist die Schwingungstilgungsvorrichtung 10' über mindestens ein zusätzliches Befestigungsmittel 16' an dem Schaltungsträger 24 befestigt. Im dargestellten zweiten Ausführungsbeispiel ist das Befestigungsmittel 16' als Lötschicht und/oder Schweißschicht und/oder Kleberschicht zwischen dem elastischen Werkstoff 12' und dem Schaltungsträger 24 angeordnet. Zur Umsetzung einer Löt- und/oder Schweißverbindung kann eine zusätzliche Interfaceschicht, beispielsweise in Form einer Metallscheibe, vorgesehen werden, über welche der elastische Werkstoff 12' mit dem Schaltungsträger 24 verbunden wird. Dieser Aufbau ermöglicht in vorteilhafter Weise eine SMD-Bestückung des Schaltungsträgers 24 mit der Schwingungstilgungsvorrichtung 10'.

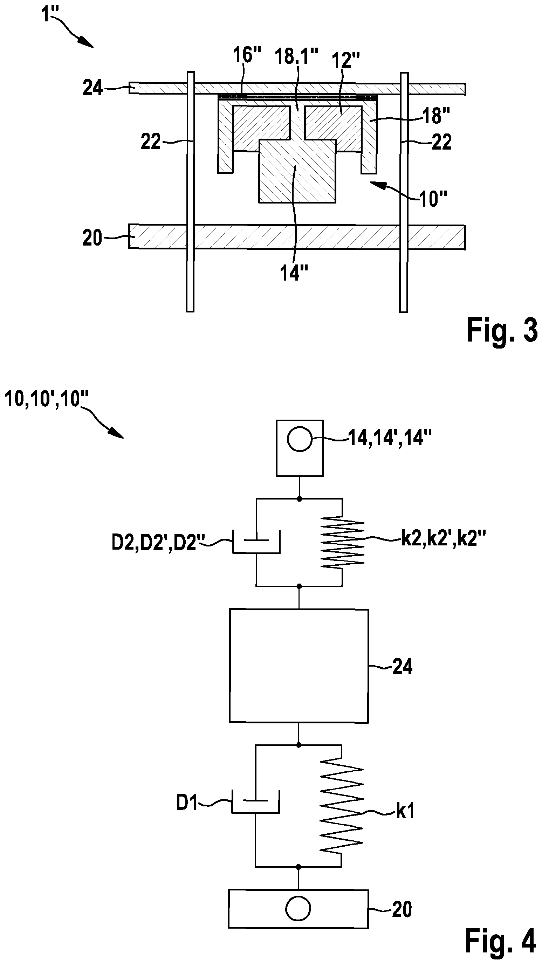

Wie aus Fig. 3 weiter ersichtlich ist, weist das dargestellte dritte Ausführungsbeispiel einer Schwingungstilgungsvorrichtung 10"eine Schale 18" auf, in welcher der elastische Werkstoff 12" und die mindestens eine Tilgermasse 14" angeordnet sind. Beim dargestellten dritten Ausführungsbeispiel ist der elastische Werkstoff 12" als Füllstoff ausgeführt, welcher die mindestens eine Tilgermasse 14" zumindest teilweise umgibt. Durch die Verwendung der Schale 18", kann der verwendete Füllstoff 12"als Gel ausgeführt werden, wodurch sich die Anzahl von möglichen elastischen Werkstoffen 12"in vorteilhafter Weise erhöht. Wie aus Fig. 3 weiter ersichtlich ist, ist die Tilgermasse 14" beim dritten Ausführungsbeispiel über einen Stab 18.1" mit der Schale 18" gekoppelt bzw. befestigt. Dieser Aufbau ermöglicht eine Trennung bzw. Entkopplung der Steifigkeitseigenschaften k2"und der Dämpfungseigenschaften D2" der Schwingungstilgungsvorrichtung 10". So können die Steifigkeitseigenschaften k2" der Schwingungstilgungsvorrichtung (10") über die Materialeigenschaften und die Ausführung des Stabes 18.1" eingestellt werden, und die Dämpfungseigenschaften D2" der Schwingungstilgungsvorrichtung 10" können über die Materialeigenschaften des Füllstoffs 12" eingestellt werden. Hierbei kann eine schnelle und leichte Adaption auf sich ändernde Resonanzfrequenzen bei unterschiedlichen Leiterplattenlayouts durch schnelles und gezieltes Variieren der Dämpfungseigenschaften D2" und der Steifigkeitseigenschaften k2" erzielt werden.

Analog zum zweiten Ausführungsbeispiel ist das Befestigungsmittel 16" im dargestellten dritten Ausführungsbeispiel ebenfalls als Lötschicht und/oder Schweißschicht und/oder Kleberschicht ausgeführt. Im Unterschied zum zweiten Ausführungsbeispiel ist das Befestigungsmittel 16" jedoch nicht zwischen dem elastischen Werkstoff 12' und dem Schaltungsträger 24, sondern zwischen der Schale 18" und dem Schaltungsträger 24 angeordnet. Wie aus Fig. 3 weiter ersichtlich ist, ist die Schwingungstilgungsvorrichtung 10" im dritten Ausführungsbeispiel analog zum ersten Ausführungsbeispiel an der Unterseite des Schaltungsträgers 24 angeordnet. Alternativ kann die Schwingungstilgungsvorrichtung 10" gemäß dem dritten Ausführungsbeispiel aber auch an der Oberseite des Schaltungsträgers 24 angeordnet werden.

Wie aus Fig. 1 bis 3 weiter ersichtlich ist gibt der elastische Werkstoff 12, 12', 12" die Bewegung der mindestens einen Tilgermasse 14, 14', 14" in mindestens eine vorgegebene Raumrichtung frei. Hierbei kann eine translatorische und eine rotatorische Schwingungsmode bei nahezu gleicher Resonanzfrequenz gedämpft werden, da eine Schwingungsdämpfung durch den elastischen Werkstoff 12, 12', 12" in unterschiedliche Richtungen einer Fläche wirksam ist.

Wie aus Fig. 4 weiter ersichtlich ist erfolgt durch eine Vibrationsanregung des elektronischen Geräts 1, 1', 1" üblicherweise eine Ausbildung von Schwingungsmoden des Schaltungsträgers 24, welche zu Schwingungen des Schaltungsträgers 24 relativ zu einem Gehäuse 20 des elektronischen Geräts führen können. Hierbei werden die äußeren Schwingungen in Abhängigkeit der Dämpfungseigenschaften D1 und/oder der Steifigkeitseigenschaften k1 des Gehäuses 20 und/oder der Befestigungspins 22 und/oder des Schaltungsträgers 24 auf den Schaltungsträger 24 übertragen. Erfindungsgemäß werden Schwingungsmoden des Schaltungsträgers 24 durch Ausführungsformen der erfindungsgemäßen Schwingungstilgungsvorrichtung 10, 10', 10" gedämpft, wobei eine schwingende Tilgermasse 14, 14', 14" dem schwingendem Schaltungsträger 24 in Abhängigkeit der Dämpfungseigenschaften D2, D2', D2" und/oder der Steifigkeitseigenschaften k2, k2', k2" der Schwingungstilgungsvorrichtung 10, 10', 10" Energie entzieht, wodurch die Schwingungsüberhöhung in vorteilhafter Weise reduziert werden kann.

Es gilt zu berücksichtigen, dass sich die Masse der Schwingungstilgungsvorrichtung 10, 10', 10" aus der Masse der mindestens einen Tilgermasse 14, 14', 14", der Masse des elastischen Werkstoffs 12, 12', 12" und je nach Ausführungsbeispiel aus der Masse der Schale 18"und des Stabs 18.1" zusammensetzt.

Ein in den Fig. 1 bis 4 dargestellte elektronische Gerät 1, 1', 1" kann als elektronisches Steuergerät mit mindestens einem Schaltungsträger ausgeführt werden. Um kritische Vibrationsbelastungen, welche zu Geräuschentwicklung oder zum Ausfall von Bauelementen, wie beispielsweise Sensoren führen können, abzumildern können die oben beschriebenen erfindungsgemäßen Schwingungstilgungsvorrichtungen 10, 10', 10" eingesetzt werden.

## Patentansprüche

1. Schwingungstilgungsvorrichtung für einen Schaltungsträger mit mindestens einer Tilgermasse (14, 14', 14"), wobei die mindestens eine Tilgermasse (14, 14', 14") an dem Schaltungsträger (24) befestigt ist und zwischen der mindestens einen Tilgermasse (14, 14', 14") und dem Schaltungsträger (24) ein elastischer Werkstoff (12, 12', 12") mit einer definierten Steifigkeit und/oder Dämpfungseigenschaft angeordnet ist, **dadurch gekennzeichnet, dass** die Schwingungstilgungsvorrichtung (10") eine Schale (18") aufweist, in welcher der elastische Werkstoff (12") und die mindestens eine Tilgermasse (14") angeordnet sind, wobei der elastische Werkstoff (12") als Füllstoff ausgeführt ist, welcher die mindestens eine Tilgermasse (14") zumindest teilweise umgibt, wobei die mindestens eine Tilgermasse (14") über einen Stab (18.1 ") mit der Schale (18") gekoppelt ist, wobei über die Materialeigenschaften des Stabes (18.1 ") die Steifigkeitseigenschaften (k2") der Schwingungstilgungsvorrichtung (10") einstellbar sind, und wobei über die Materialeigenschaften des Füllstoffs die Dämpfungseigenschaften (D2") der Schwingungstilgungsvorrichtung (10") einstellbar sind.

2. Vorrichtung nach Anspruch 1, **dadurch gekennzeichnet, dass** der elastische Werkstoff (12, 12') als Dämpfungsschicht ausgeführt ist, wobei über die Materialeigenschaften und/oder über die Geometrie der Dämpfungsschicht die Dämpfungseigenschaften (D2, D2') und/oder die Steifigkeitseigenschaften (k2, k2') der Schwingungstilgungsvorrichtung (10, 10') einstellbar sind.

3. Vorrichtung nach Anspruch 1 oder 2, **dadurch gekennzeichnet, dass** der elastische Werkstoff (12, 12', 12") die Bewegung der mindestens einen Tilgermasse (14, 14', 14") in mindestens eine vorgegebene Raumrichtung freigibt.

4. Vorrichtung nach einem der Ansprüche 1 bis 3, **dadurch gekennzeichnet**, die mindestens eine Tilgermasse (14, 14', 14") und/oder der elastische Werkstoff (12, 12', 12") auf die zu dämpfende Frequenz abgestimmt sind.

5. Vorrichtung nach einem der Ansprüche 1 bis 4, **dadurch gekennzeichnet, dass** die Schwingungstilgungsvorrichtung (10, 10', 10") über mindestens ein Befestigungsmittel (16',16") an dem Schaltungsträger (24) befestigbar ist.

6. Vorrichtung nach Anspruch 5, **dadurch gekennzeichnet, dass** das Befestigungsmittel (16', 16") an einer Kotaktfläche (16.1', 16.1") angebracht ist, welche an dem elastischen Werkstoff (12') und/oder an der Schale (18") angeordnet ist.

7. Elektronisches Gerät mit einem Schaltungsträger (24), welcher über Befestigungspins (16) mit einem Gehäuse (20) verbunden ist, wobei auf dem Schaltungsträger (24) mindestens ein Bauteil befestigt ist, wobei äußere Schwingungen über das Gehäuse (20) und/oder über die Befestigungspins (22) auf den Schaltungsträger (24) und/oder auf das mindestens eine Bauteil übertragbar sind, **dadurch gekennzeichnet, dass** eine Schwingungstilgungsvorrichtung (10, 10', 10") nach einem der Ansprüche 1 bis 6 die äußeren Schwingungen dämpft.

8. Elektronisches Gerät nach Anspruch 7 **dadurch gekennzeichnet, dass** die Schwingungstilgungsvorrichtung (10, 10', 10") zur Schwingungstilgung an der Oberseite und/oder an der Unterseite des Schaltungsträgers (24) befestigt ist.

## Claims

1. Vibration absorption device for a circuit carrier, having at least one absorption mass (14, 14', 14''), wherein the at least one absorption mass (14, 14', 14'') is attached to the circuit carrier (24), and between the at least one absorption mass (14, 14', 14") and the circuit carrier (24) there is arranged an elastic material (12, 12', 12") with a defined stiffness and/or damping property, **characterized in that** the vibration absorption device (10") has a shell (18") in which are arranged the elastic material (12") and the at least one absorption mass (14"), wherein the elastic material (12") takes the form of a filler material which at least partially surrounds the at least one absorption mass (14"), wherein the at least one absorption mass (14") is coupled to the shell (18") by means of a rod (18.1"), wherein the stiffness properties (k2") of the vibration absorption device (10") can be set by means of the material properties of the rod (18.1"), and wherein the damping properties (D2") of the vibration absorption device (10") can be set by means of the material properties of the filler material.

2. Device according to Claim 1, **characterized in that** the elastic material (12, 12') takes the form of a damping layer, wherein the damping properties (D2, D2') and/or the stiffness properties (k2, k2') of the vibration absorption device (10, 10') can be set by means of the material properties and/or the geometry of the damping layer.

3. Device according to Claim 1 or 2, **characterized in that** the elastic material (12, 12', 12") leaves the at least one absorption mass (14, 14', 14'') free to move in at least one predefined spatial direction.

4. Device according to one of Claims 1 to 3, **characterized in that** the at least one absorption mass (14, 14', 14") and/or the elastic material (12, 12', 12") are adapted to the frequency that is to be damped.

5. Device according to one of Claims 1 to 4, **characterized in that** the vibration absorption device (10, 10', 10") can be attached to the circuit carrier (24) by means of at least one attachment means (16', 16").

6. Device according to Claim 5, **characterized in that** the attachment means (16', 16") is applied to a contact surface (16.1', 16.1") which is arranged on the elastic material (12') and/or on the shell (18").

7. Electronic device having a circuit carrier (24) that is connected to a housing (20) by means of attachment pins (16), wherein at least one component is attached to the circuit carrier (24), wherein external vibrations can be transmitted to the circuit carrier (24) and/or to the at least one component via the housing (20) and/or via the attachment pins (22), **characterized in that** a vibration absorption device (10, 10', 10") according to one of Claims 1 to 6 damps the external vibrations.

8. Electronic device according to Claim 7, **characterized in that** the vibration absorption device (10, 10', 10") for vibration absorption is attached to the top side and/or to the underside of the circuit carrier (24).

## Revendications

1. Dispositif d'amortissement de vibrations pour un support de circuit avec au moins une masse d'amortissement (14, 14', 14"), dans lequel l'au moins une masse d'amortissement (14, 14', 14'') est fixée au support de circuit (24), et entre l'au moins une masse d'amortissement (14, 14', 14") et le support de circuit (24), un matériau élastique (12, 12', 12") avec une rigidité et/ou propriété d'amortissement définie est disposé, **caractérisé en ce que** le dispositif d'amortissement de vibrations (10") présente une coque (18") dans laquelle le matériau élastique (12") et l'au moins une masse d'amortissement (14") sont disposés, dans lequel le matériau élastique (12") est réalisé en tant que masse de remplissage qui entoure au moins partiellement l'au moins une masse d'amortissement (14"), dans lequel l'au moins une masse d'amortissement (14") est couplée via une tige (18.1") avec la coque (18"), dans lequel, via les propriétés de matériau de la tige (18.1"), les propriétés de rigidité (k2") du dispositif d'amortissement de vibrations (10") sont réglables, et dans lequel, via les propriétés de matériau de la masse de remplissage, les propriétés d'amortissement (D2") du dispositif d'amortissement de vibrations (10") sont réglables.

2. Dispositif selon la revendication 1, **caractérisé en ce que** le matériau élastique (12, 12') est réalisé en tant que couche d'amortissement, dans lequel, via les propriétés de matériau et/ou via la géométrie de la couche d'amortissement, les propriétés d'amortissement (D2, D2') et/ou les propriétés de rigidité (k2, k2') du dispositif d'amortissement de vibrations (10, 10') sont réglables.

3. Dispositif selon la revendication 1 ou 2, **caractérisé en ce que** le matériau élastique (12, 12', 12") libère le mouvement de l'au moins une masse d'amortissement (14, 14', 14") dans au moins une direction spatiale prescrite.

4. Dispositif selon l'une des revendications 1 à 3, **caractérisé en ce que** l'au moins une masse d'amortissement (14, 14', 14") et/ou le matériau élastique (12, 12', 12") sont adaptés à la fréquence à amortir.

5. Dispositif selon l'une des revendications 1 à 4, **caractérisé en ce que** le dispositif d'amortissement de vibrations (10, 10', 10") peut être fixé via au moins un moyen de fixation (16', 16") au support de circuit (24).

6. Dispositif selon la revendication 5, **caractérisé en ce que** le moyen de fixation (16', 16") est agencé au niveau d'une surface de contact (16.1', 16.1") qui est disposée au niveau du matériau élastique (12') et/ou au niveau de la coque (18").

7. Appareil électronique avec un support de circuit (24) raccordé via des broches de fixations (16) à un boîtier (20), dans lequel au moins un composant est fixé sur le support de circuit (24), dans lequel des vibrations extérieures peuvent être transmises via le boîtier (20) et/ou via les broches de fixation (22) au support de circuit (24) et/ou à l'au moins un composant, **caractérisé en ce qu'**un dispositif d'amortissement de vibrations (10, 10', 10") selon l'une des revendications 1 à 6 amortit les vibrations extérieures.

8. Appareil électronique selon la revendication 7, **caractérisé en ce que** le dispositif d'amortissement de vibrations (10, 10', 10") pour l'amortissement de vibrations est fixé au niveau de la face supérieure et/ou au niveau de la face inférieure du support de circuit (24).
